# EUROPÄISCHE PATENTANMELDUNG

(11) **EP 2 096 423 A2**
(43) Veröffentlichungstag der Anmeldung: **02.09.2009**
(21) Anmeldenummer: 08105868.7
(22) Anmeldetag: 26.11.2008
(51) Int. Cl.: G01L 19/14

(54) **Sensoranordnung**

(30) Priorität: 29.02.2008 DE 102008011943
(71) Anmelder: ROBERT BOSCH GMBH, 70442 Stuttgart (DE)
(72) Erfinder: Ochs, Eric, 72072, Tuebingen (DE); Henzler, Stephan, 72810, Gomaringen (DE); Nitsche, Heiko, 72760, Reutlingen (DE); Benzel, Hubert, 72124, Pliezhausen (DE); Haag, Frieder, 72827, Wannweil (DE)

(57) **Zusammenfassung**

Die vorliegende Erfindung betrifft eine Sensoranordnung (10) mit mindestens einem Sensorelement (20), das auf einem Träger (25) angeordnet ist, und mit einem Moldgehäuse (30), in das ein Bereich des Sensorelements (21) und des Trägers (25) eingebettet ist, wobei das Moldgehäuse (39) mindestens eine Durchgangsöffnung (31) als Zugangsöffnung für den sensitiven Bereich (22) des Sensorelements (20) aufweist.

Um eine räumliche Trennung zwischen der Gehäuseoberseite und der Gehäuseunterseite einer solchen Sensoranordnung (10) zu realisieren, erstreckt sich der Träger (25) über den gesamten Querschnitt der Durchgangsöffnung (31) und ist im Randbereich der Durchgangsöffnung (31) in das Moldgehäuse (30) eingebettet.

## Beschreibung

### Stand der Technik

Die Erfindung betrifft eine Sensoranordnung mit mindestens einem Sensorelement, das auf einem Träger angeordnet ist, und mit einem Moldgehäuse, in das ein Bereich des Sensorelements und des Trägers eingebettet ist, wobei das Moldgehäuse mindestens eine Durchgangsöffnung als Zugangsöffnung für den sensitiven Bereich des Sensorelements aufweist.

Die Erfindung bezieht sich insbesondere auf Sensoren, wie z.B. Druck- oder Luftmassensensoren oder auch optische Sensoren, die applikationsbedingt Kontakt zu einem Messmedium benötigen. Gleichzeitig besteht hier die Notwendigkeit, die elektrischen Verbindungen und Kontakte des Sensorelements sowie die dazugehörigen Schaltungsteile zu schützen, da diese zumeist von dem Messmedium angegriffen werden. Bei einigen Anwendungen, wie z.B. bei Drucksensoren für den Seitenairbag eines Kfzs, erfolgt die Ankopplung des Sensorelements an die Umgebung daher über eine zum Innenraum des Kfz-Außengehäuses hin abgedichtete Verbindung. Die zu schützenden Teile des Sensors werden hier innenseitig angeordnet, während die eigentliche Sensorkomponente den Umgebungseinflüssen ausgesetzt ist.

In der deutschen Offenlegungsschrift DE 10 205 038 443 A1 wird eine Sensoranordnung der eingangs genannten Art beschrieben. Das Moldgehäuse des Sensorelements ist hier so dimensioniert, dass es das Sensorelement allseitig umgibt. Allerdings ist in dem Moldgehäuse eine Freisparung ausgebildet, über die der sensitive Bereich des Sensorelements frei zugänglich ist. Diese Freisparung erstreckt sich herstellungsbedingt über die gesamte Dicke des Gehäuses und bildet so eine Durchgangsöffnung im Moldgehäuse. Gemäß der DE 10 205 038 443 A1 ist lediglich ein Abschnitt des Sensorelements in das Moldgehäuse eingebunden. Dieser Abschnitt des Sensorelements ist mit einem Träger in Form eines Leadframe verbunden. In diesem Bereich angeordnete Schaltungsteile werden durch die Moldmasse des Gehäuses geschützt. Im Unterschied dazu ragt der sensitive Bereich des Sensorelements frei in die Durchgangsöffnung des Moldgehäuses, so dass der sensitive Bereich des Sensorelements und das Moldgehäuse weitestgehend thermisch entkoppelt sind.

Die aus der DE 10 205 038 443 A1 bekannte Sensoranordnung stellt keine Barriere für das Messmedium dar. Das Messmedium tritt an einer Gehäuseseite in die Freisparung ein, umströmt den sensitiven Bereich des Sensorelements und kann dann ungehindert an der anderen Gehäuseseite wieder austreten. Aus diesem Grund eignet sich diese Sensoranordnung nicht für den Einbau in einer abgedichteten Verbindung zwischen Raumbereichen, wie z.B. im Innenraum eines Kfz-Außengehäuses.

### Offenbarung der Erfindung

Mit der vorliegenden Erfindung wird eine Weiterentwicklung der bekannten Sensoranordnung vorgeschlagen, mit der sich eine räumliche Trennung zwischen der Gehäuseoberseite und der Gehäuseunterseite der Sensoranordnung realisieren lässt.

Dies wird erfindungsgemäß dadurch erreicht, dass sich der Träger über den gesamten Querschnitt der Durchgangsöffnung erstreckt und im Randbereich der Durchgangsöffnung in das Moldgehäuse eingebettet ist.

Erfindungsgemäß ist erkannt worden, dass sich die Durchgangsöffnung im Moldgehäuse einfach und zuverlässig mit Hilfe des Trägers verschließen lässt, indem der Träger entsprechend dimensioniert und im Randbereich der Durchgangsöffnung in die Moldmasse des Gehäuses eingebettet wird. Die auf das Moldgehäuse zurückzuführenden Vorteile der bekannten Sensoranordnung bleiben dabei erhalten, nämlich wirkungsvoller Schutz des Sensorelements gegen mechanische und chemische Umwelteinflüsse bei einfacher und kostengünstiger Herstellung, ohne das ein zusätzlicher Schutz von Schaltungsteilen auf dem Sensorelement erforderlich ist. Vorteilhafterweise lässt sich durch die erfindungsgemäßen Maßnahmen auch die thermische Entkopplung des sensitiven Bereichs des Sensorelements vom Gehäuse aufrechterhalten.

In einer bevorzugten Ausführungsform der erfindungsgemäßen Sensoranordnung ist das Sensorelement lediglich einseitig in das Moldgehäuse eingebunden, so dass der sensitive Bereich in die Durchgangsöffnung des Moldgehäuses hineinragt. Wie bereits erwähnt, lässt sich dadurch eine besonders gute thermische Entkopplung des sensitiven Bereichs vom Gehäuse erzielen.

Zur Herstellung des Moldgehäuses wird das auf dem Träger montierte Sensorelement mit der Moldmasse des Gehäuses umspritzt, wobei eine Freisparung in der Umgebung des sensitiven Bereichs erzeugt wird. Vorteilhafterweise werden bei der Montage des Sensorelements auf dem Träger lediglich die Bereiche miteinander verbunden, die danach auch gemeinsam in das Moldgehäuse eingebettet werden. Durch diese Maßnahme lassen sich mechanische Verspannungen des sensitiven Bereichs einfach vermeiden, die auf unterschiedliche thermische Ausdehnungskoeffizienten der Materialien des Sensorelements einerseits und des Trägers andererseits zurückzuführen sind.

Bei der Verbindung zwischen Sensorelement und Träger kann es sich um eine Klebeverbindung handeln. Durch die Klebeschicht zwischen dem Sensorelement und dem Träger im Bereich des Gehäuses wird der sensitive Bereich in vorteilhafter Weise auf Abstand zum Träger gehalten. Zumindest kann dadurch einfach gewährleistet werden, dass der sensitive Bereich des Sensorelements lose auf dem Träger aufliegt. Der Träger kann auch im Bereich der Durchgangsöffnung zumindest einseitig abgedünnt sein, so dass der sensitive Bereich des Sensorelements vom Träger beabstandet ist. Diese Maßnahme trägt ebenfalls zur thermischen Entkopplung des sensitiven Bereichs des Sensorelements vom Träger bei.

Die voranstehend beschriebenen Varianten einer erfindungsgemäßen Sensoranordnung, bei denen der sensorische Bereich des Sensorelements lose in die Durchgangsöffnung des Moldgehäuses ragt, eignen sich besonders für Anwendungen, bei denen das Sensorelement bzw. der sensorische Bereich lediglich einseitig mit dem Messmedium in Kontakt tritt. Beispiele hierfür sind die Luftmassenbestimmung oder die Absolutdruckerfassung. In diesen Fällen bildet eine Membran über einem abgeschlossenen Volumen den sensitiven Bereich des Sensorelements.

Die erfindungsgemäße Sensoranordnung lässt sich aber auch für Anwendungen konzipieren, bei denen der sensorische Bereich des Sensorelements zweiseitig mit Messmedien in Kontakt tritt, wie z. B. bei der Differenzdruckerfassung. In diesem Fall umfasst der sensorische Bereich des Sensorelements mindestens eine Membran, die sowohl von der Oberseite als auch von der Rückseite des Sensorelements zugänglich ist. Die rückseitige Druckbeaufschlagung dieser Membran erfolgt über eine im Träger ausgebildete Zugangsöffnung unterhalb der Membran. Zur räumlichen Trennung zwischen der Membranoberseite und der Membranrückseite, und damit auch zwischen der Gehäuseoberseite und der Gehäuseunterseite der Sensoranordnung, sind das Sensorelement und der Träger bei dieser Variante auch im Bereich der Durchgangsöffnung druckdicht miteinander verbunden.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die dem unabhängigen Patentanspruch 1 nachgeordneten Patentansprüche und andererseits auf die nachfolgende Beschreibung mehrerer Ausführungsbeispiele der Erfindung anhand der Zeichnungen verwiesen.
- **Fig. 1**: zeigt eine schematische Schnittdarstellung einer ersten erfindungsgemäßen Sensoranordnung und
- **Fig. 2**: zeigt eine schematische Schnittdarstellung einer zweiten erfindungsgemäßen Sensoranordnung.

### Ausführungsformen der Erfindung

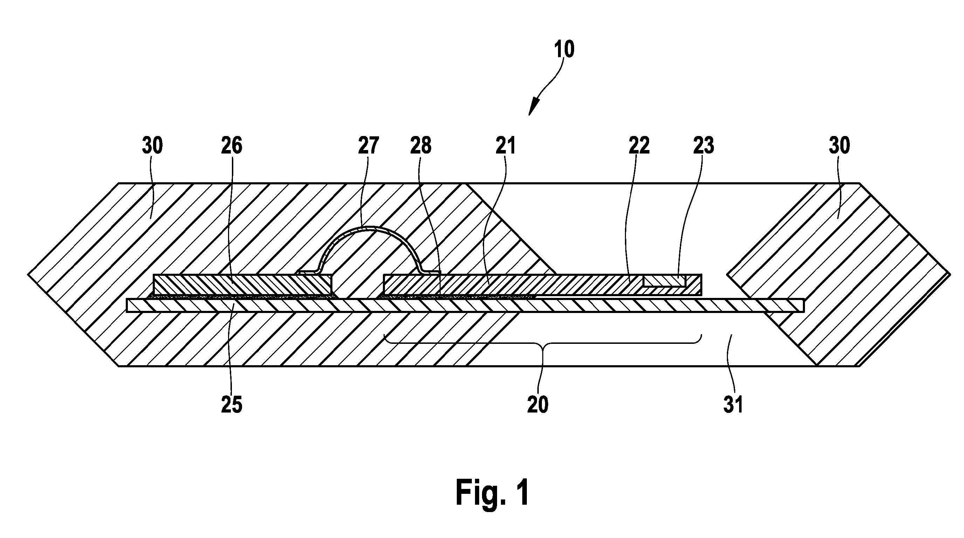

Die in **Fig. 1** dargestellte Sensoranordnung 10 umfasst ein Sensorelement 20, das auf einem Träger 25 angeordnet ist. Im mit 22 bezeichneten sensorischen Bereich des Sensorelements 20 ist eine mikromechanische Sensorstruktur 23 in Form einer Membran über einem abgeschlossenen Volumen ausgebildet. Diese Sensorstruktur 23 wird hier zur Absolutdruckerfassung eingesetzt, indem Deformationen der Membran piezoresistiv erfasst werden. Die elektrischen Anschlüsse der dafür erforderlichen Piezowiderstände sind in den Bereich 21 des Sensorelements 20 geführt, wo sich auch Teile einer Auswerteschaltung befinden. Diese Schaltungsteile sind über Bonddrähte 27 mit einem Auswertechip 26 verbunden, der ebenfalls auf dem Träger 25 angeordnet ist.

Des Weiteren umfasst die Sensoranordnung 10 ein Moldgehäuse 30 mit einer Freisparung 31 als Zugangsöffnung für den sensitiven Bereich 22 des Sensorelements 20. Der Auswertechip 26, die Bonddrähte 27 und der Bereich 21 des Sensorelements 20 sind zusammen mit dem entsprechenden Abschnitt des Trägers 25 in die Moldmasse des Gehäuses 30 eingebettet, so dass das Gehäuse 30 diese Teile der Sensoranordnung 10 nicht nur gegen mechanische Einwirkungen schützt, sondern auch gegen das Messmedium. Herstellungsbedingt erstreckt sich die Freisparung 31 über die gesamte Dicke des Moldgehäuses 30 und bildet so eine Durchgangsöffnung 31 im Gehäuse 30. Erfindungsgemäß erstreckt sich der Träger 25 über den gesamten Querschnitt der Durchgangsöffnung 31 und ist im Randbereich der Durchgangsöffnung 31 in das Moldgehäuse 30 eingebettet. Im hier dargestellten Ausführungsbeispiel verschließt der Träger 25 die Durchgangsöffnung 31 und gewährleistet so eine räumliche Trennung zwischen der Gehäuseoberseite und der Gehäuseunterseite der Sensoranordnung 10.

Während der gesamte Randbereich des Trägers 25 in die Moldmasse des Gehäuses 30 eingebettet ist, ragt der sensitive Bereich 22 des Sensorelements 20 frei in die Durchgangsöffnung 31 des Gehäuses 30. Dadurch ist der sensitive Bereich 22 vom Gehäuse 30 weitgehend thermisch entkoppelt. Außerdem ist lediglich der im Moldgehäuse 30 eingebettete Bereich 21 des Sensorelements 20 über eine Klebeschicht 28 mit dem Träger 25 verbunden. Je nach Dicke der Klebeschicht 28 liegt der sensitive Bereich 22 des Sensorelements 20 lose auf dem Träger 25 auf oder ist sogar von diesem beabstandet. Dadurch ist der sensitive Bereich 22 des Sensorelements 20 auch vom Träger 25 weitgehend thermisch entkoppelt, so dass unterschiedliche Temperaturkoeffizienten des Trägermaterials und des Sensorelements 20 nicht zu thermisch bedingten mechanischen Spannungen im sensitiven Bereich 22 des Sensorelements 20 führen.

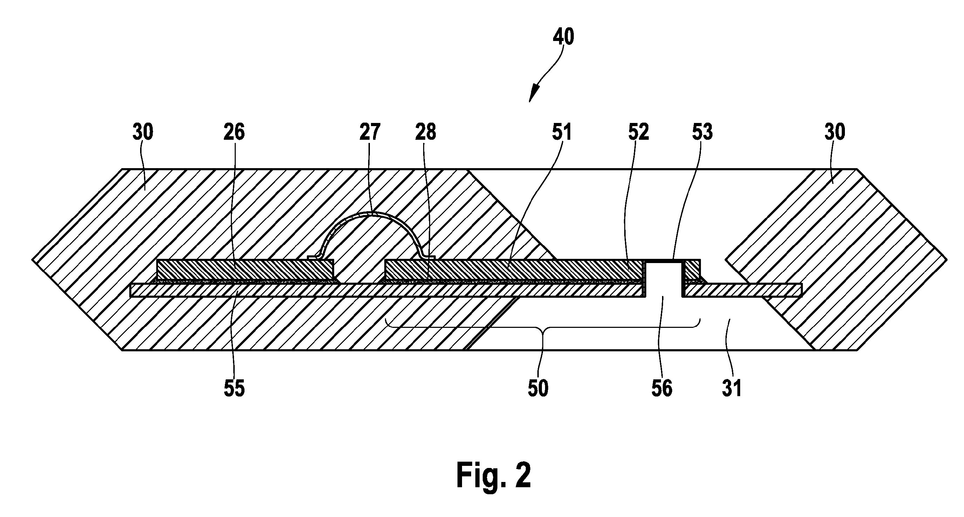

Der Aufbau der in **Fig. 2** dargestellten Sensoranordnung 40 entspricht im Wesentlichen dem Aufbau der Sensoranordnung 10, so dass gleiche Komponenten mit denselben Bezugszeichen versehen sind. Wie die in Fig. 1 dargestellte Sensoranordnung 10 umfasst die Sensoranordnung 40 ein Sensorelement 50, das auf einem Träger 55 angeordnet ist. Im Unterschied zur Sensoranordnung 10 dient die Sensoranordnung 40 jedoch zur Differenzdruckerfassung. Dementsprechend ist die im sensorischen Bereich 52 des Sensorelements 50 ausgebildete Membran 53 sowohl von der Oberseite als auch von der Rückseite ausgehend mit Druck beaufschlagbar, was nachfolgend noch näher erläutert wird. Die Membrandeformationen werden auch hier piezoresistiv erfasst und mit Hilfe eines Chips 26 ausgewertet. Die elektrischen Anschlüsse der Piezowiderstände sind in den Bereich 51 des Sensorelements 50 geführt und über Bonddrähte 27 mit einem Auswertechip 26 verbunden, der ebenfalls auf dem Träger 55 angeordnet ist. Der Auswertechip 26, die Bonddrähte 27 und der Bereich 51 des Sensorelements 50 sind zusammen mit dem entsprechenden Abschnitt des Trägers 55 in ein Moldgehäuse 30 eingebettet, so dass das Gehäuse 30 diese Teile der Sensoranordnung 40 nicht nur gegen mechanische Einwirkungen schützt, sondern auch gegen das Messmedium. Im Moldgehäuse 30 der Sensoranordnung 40 ist eine Freisparung 31 als Zugangsöffnung für den sensitiven Bereich 52 des Sensorelements 50 ausgebildet. Erfindungsgemäß erstreckt sich der Träger 55 über den gesamten Querschnitt dieser Durchgangsöffnung 31 und ist in deren Randbereich in das Moldgehäuse 30 eingebettet.

Während der gesamte Randbereich des Trägers 55 in die Moldmasse des Gehäuses 30 eingebettet ist, ist das Sensorelement 50 nur einseitig in das Gehäuse 30 eingebunden, so dass der sensitive Bereich 52 in die Durchgangsöffnung 31 des Gehäuses 30 ragt. Dadurch wird eine sehr gute thermische Entkopplung des sensitiven Bereichs 52 vom Gehäuse 30 erzielt. Außerdem werden auch die auf das Sensorelement 50 wirkenden Einspannkräfte durch die laterale Entfernung der Membran 53 zur Moldmasse des Gehäuses 30 sehr gut abgebaut.

Wie bereits erwähnt, wird die Membran 53 zur Differenzdruckerfassung sowohl von der Oberseite des Sensorelements 50 als auch von dessen Rückseite ausgehend mit Druck beaufschlagt. Die rückseitige Druckbeaufschlagung erfolgt über eine entsprechend angeordnete Zugangsöffnung 56 im Träger 55 im Bereich der Durchgangsöffnung 31 im Moldgehäuse 30. Um die für eine Differenzdruckerfassung erforderliche räumliche Trennung zwischen der Membranoberseite und der Membranrückseite zu gewährleisten, ist hier nicht nur der im Moldgehäuse 30 angeordnete Bereich 51 des Sensorelements 50 mit dem Träger 55 verbunden, sondern auch der sensitive Bereich 52, der in die Durchgangsöffnung 31 des Gehäuses 30 ragt. Diese druckdichte Verbindung wird hier mit Hilfe einer Klebeschicht 28 realisiert.

## Patentansprüche

1. Sensoranordnung (10) mit mindestens einem Sensorelement (20), das auf einem Träger (25) angeordnet ist, und mit einem Moldgehäuse (30), in das ein Bereich des Sensorelements (21) und des Trägers (25) eingebettet ist, wobei das Moldgehäuse (39) mindestens eine Durchgangsöffnung (31) als Zugangsöffnung für den sensitiven Bereich (22) des Sensorelements (20) aufweist,
**dadurch gekennzeichnet, dass** sich der Träger (25) über den gesamten Querschnitt der Durchgangsöffnung (31) erstreckt und im Randbereich der Durchgangsöffnung (31) in das Moldgehäuse (30) eingebettet ist.

2. Sensoranordnung (10) nach Anspruch 1, **dadurch gekennzeichnet, dass** das Sensorelement (20) mit seinem sensitiven Bereich (22) in die Durchgangsöffnung (31) des Moldgehäuses (30) hineinragt.

3. Sensoranordnung (10) nach einem der Ansprüche 1 oder 2, **dadurch gekennzeichnet, dass** das Sensorelement (20) und der Träger (25) lediglich in dem Bereich, der in das Moldgehäuse (30) eingebettet ist, miteinander verbunden sind.

4. Sensoranordnung (10) nach einem der Ansprüche 1 bis 3, **dadurch gekennzeichnet, dass** es sich bei der Verbindung zwischen Sensorelement (20) und Träger (25) um eine Klebeverbindung handelt.

5. Sensoranordnung (10) nach einem der Ansprüche 1 bis 4, **dadurch gekennzeichnet, dass** der sensitive Bereich (22) des Sensorelements (20) lose auf dem Träger (25) aufliegt.

6. Sensoranordnung nach einem der Ansprüche 1 bis 4, **dadurch gekennzeichnet, dass** der Träger im Bereich der Durchgangsöffnung zumindest einseitig abgedünnt ist, so dass der sensitive Bereich des Sensorelements vom Träger beabstandet ist.

7. Sensoranordnung (40) zur Differenzdruckmessung nach einem der Ansprüche 1 bis 3, **dadurch gekennzeichnet, dass** das Sensorelement (50) und der Träger (55) auch im Bereich der Durchgangsöffnung (31) druckdicht miteinander verbunden sind, dass der sensorische Bereich (52) des Sensorelements (50) mindestens eine Membran (53) umfasst, die sowohl von der Oberseite als auch von der Rückseite des Sensorelements (50) zugänglich ist, und dass der Träger (55) im Bereich unterhalb der Membran (53) eine Zugangsöffnung (56) aufweist.
